# DEMANDE DE BREVET EUROPEEN

(11) **EP 0 716 508 A1**
(43) Date de publication de la demande: **12.06.1996**
(21) Numéro de dépôt: 95402759.5
(22) Date de dépôt: 07.12.1995
(51) Int. Cl.: H03K 17/082

(54) **Circuit de commande pour interrupteur électronique et interrupteur en faisant application**

(30) Priorité: 09.12.1994 FR 9414822
(71) Demandeur: ALCATEL ALSTHOM COMPAGNIE GENERALE D'ELECTRICITE, F-75382 Paris Cédex 08 (FR)
(72) Inventeur: Lavieville, Jean-Paul, F-91190 Gif Sur Yvette (FR); Muller, Didier, F-91190 Gif Sur Yvette (FR)
(74) Mandataire: Pothet, Jean Rémy Emile Ludovic

(57) **Abrégé**

Le trajet de commande de l'interrupteur (I) comprend un étage d'entrée (T2, T1) à une entrée duquel est couplée l'entrée (E) de signal de commande, et dont la sortie est couplée à l'électrode de commande de l'interrupteur (I). Un circuit de protection (D1, Z2), inserré entre la charge (C) et le trajet de commande, comprend un composant à effet de seuil (Z2) et un élément de découplage (D1). Rendu passant par le courant résultant d'une surtension engendrée dans le circuit de la charge (C), ce circuit de protection est couplé à l'entrée dudit étage d'entrée (T2, T1), pour agir sur ledit interrupteur (I) à l'instar d'un signal de commande de l'interrupteur (I).

## Description

La présente invention concerne un circuit de commande pour interrupteur électronique et un interrupteur électronique doté d'un tel circuit de commande.

Il est bien connu qu'un interrupteur électronique, qui commande souvent l'alimentation d'une charge inductive, est soumis, au blocage de l'interrupteur et à l'ouverture du circuit d'alimentation de la charge, à une surtension qui risque d'endommager l'interrupteur.

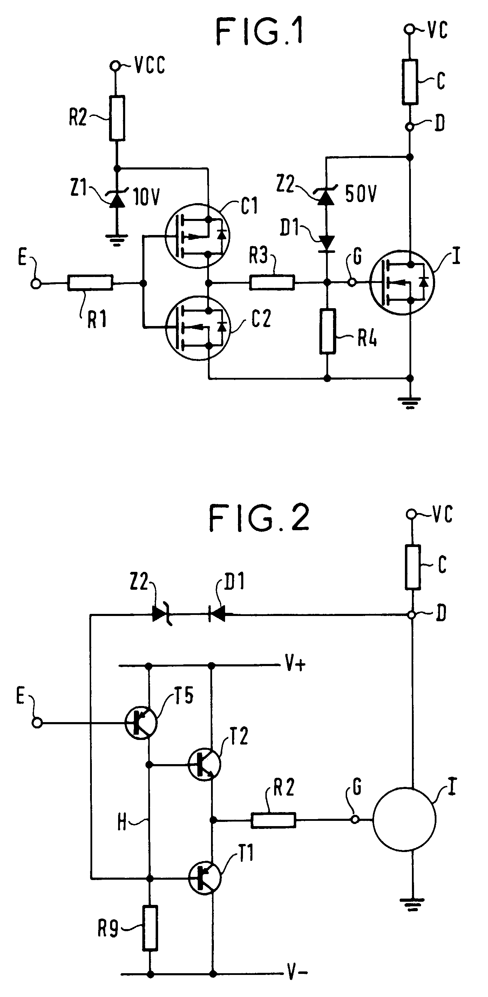

On trouvera dans l'article "The Benefits of Integration", de A. Alderman, publié dans "PCIM Europe", Novembre/Décembre 1993, une solution à ce problème. Elle est illustrée par le figure 1.

Sur cette figure, l'entrée de commande de l'interrupteur E attaque, par une résistance d'adaptation d'entrée R1, les grilles de deux transistors à effet de champ C1, C2, constituant un étage d'entrée de type "push-pull". Ces deux transistors sont disposés en série entre une source de polarisation continue dérivée de la source positive VCC par une résistance limitatrice R2 et une diode Zener Z1 de 10 V de tension de seuil, et la masse. Le point commun des deux transistors de cet étage d'entrée fournit soit la tension de 10 V développée aux bornes de la diode Zener Z1, soit la masse, aux seuils des transistors près, lorsque l'état de l'entrée E est tel qu'est saturé soit le transistor C1, soit le transistor C2. Divisé par le pont formé par les résistances R3 et R4, la tension de ce point commun, disponible au point G, commande la grille de l'interrupteur I qui est ainsi soit saturé, soit bloqué, alimentant la charge C dans le premier cas. Au moment où l'interrupteur I est bloqué, la charge C, qui est toujours plus ou moins inductive, développe une surtension sur le drain de l'interrupteur I. Pour éviter qu'une telle surtension n'endommage l'interrupteur, il est de plus prévu un circuit de protection qui consiste en une diode Zener Z2, en série avec une diode D1, connectées entre le point D, c'est-à-dire le drain de l'interrupteur I et le point G, c'est-à-dire sa grille. Sur la figure 1, à titre d'exemple, la diode Zener Z2 a un seuil de 50 V. La diode D1 est bloquée quand l'interrupteur est commandé pour être conducteur. Elle devient passante lorsqu'une surtension dépasse le seuil de conductibilité de 50 V de la diode Zener Z2 (outre son propre seuil), le courant résultant s'écoulant par la résistance R3 et le transistor C2. La résistance R4, en parallèle, peut avoir une valeur comparativement plus élevée et ne joue ici qu'un rôle négligeable. Dès que le potentiel sur la grille est suffisant, l'interrupteur I se débloque et le courant qui le traverse limite la surtension.

Lorsque le circuit de protection fonctionne, en présence d'une surtension, le courant dans Z2, D1, R3, C2 ne doit pas dépasser une valeur spécifiée, pour ne pas risquer d'endommager les éléments de ce circuit. Par contre, en tenant compte de la valeur de la résistance R3, il doit être tel que soit obtenue une tension qui soit suffisante pour rendre conducteur l'interrupteur I, mais ne risque pas d'endommager ce dernier. Cela définit une valeur souhaitable de la résistance R3. Il n'y a pas de raison que ce soit précisément celle que nécessite le circuit de commande de mise en conduction de l'interrupteur I, tel qu'on l'a défini plus haut. La valeur de la résistance R3 résulte donc généralement d'un compromis, mais il existe des cas (besoin d'obtenir des fronts de conduction raides, donc surtension élevée) où ce compromis n'est guère satisfaisant, ou même inaccessible, ce qui conduit alors à employer des composants (Z2, D1, R3, C2) capables de supporter un courant relativement élevé, au point qu'il n'est alors plus possible des les intégrer dans la même puce que l'interupteur, ce qui augmente le coût de l'ensemble interrupteur-circuit de commande.

La présente invention apporte une solution à ce problème.

Elle a ainsi pour objet un circuit de commande pour interrupteur électronique dans lequel le circuit de protection contre les surtensions n'a qu'un effet négligeable sur les conditions normales de fonctionnement du circuit de commande de l'interrupteur et néanmoins ne comprend que des composants dissipant, en présence d'une surtension, assez peu d'énergie pour être intégrables.

Cet objet est atteint dans un circuit de commande pour un interrupteur électronique alimentant une charge, comprenant un trajet de commande de l'interrupteur s'étendant entre une entrée de signal de commande et l'électrode de commande de l'interrupteur, ledit trajet de commande comprenant un étage d'entrée à une entrée duquel est couplée ladite entrée de signal de commande, et dont la sortie est couplée à l'électrode de commande de l'interrupteur électronique, et comprenant aussi un circuit de protection inserré entre ladite charge et ledit trajet de commande, qui comprend un composant à effet de seuil et un élément de découplage et qui est rendu passant par le courant résultant d'une surtension engendrée dans ladite charge. Selon l'invention, ce circuit de protection est couplé à l'entrée dudit étage d'entrée, pour agir sur ledit interrupteur à l'instar d'une signal de commande de l'interrupteur.

De la sorte, la surtension commande non plus directement l'interrupteur, mais l'étage d'entrée qui le commande, ce qui supprime pratiquement les contraintes concernant le courant engendré par la surtension.

De préférence, ladite entrée de l'étage d'entrée comprend un impédance dont la valeur est telle qu'elle protège les éléments du circuit de protection.

La détermination de cette impédance est simple, du fait qu'elle peut être élevée et que, par suite, son influence est négligeable sur les caractéristiques de fonctionnement du circuit de commande de l'interrupteur.

Les différents objets et caractéristiques de la présente invention apparaîtront plus clairement dans la description qui va suivre d'un mode de mise oeuvre de l'invention, donnée à titre d'exemple non limitatif, en se reportant aux figures annexées qui représentent :
- la figure 1, déjà décrite, le schéma de principe d'un circuit de commande pour interrupteur électronique de type connu,
- la figure 2, le schéma de principe d'un circuit de commande pour interrupteur électronique conforme à l'invention.

Dans le schéma de la figure 2, les éléments qui sont repris de celui de la figure 1 en conservant leur fonction portent les mêmes références.

C'est ainsi que l'on retrouve l'entrée de commande de l'interrupteur E, l'interrupteur I et le circuit de protection qui consiste en la diode Zener Z2 et la diode de découplage D1.

L'entrée E est connectée à la base d'un transistor de commande T5, de type PNP, dont l'émetteur est directement connecté au potentiel V+, tandis que son collecteur, polarisé au potentiel V- par une résistance R9, commande directement l'entrée H d'un étage "push-pull" comprenant deux transistors, l'un NPN, T2, et l'autre PNP, T1, analogue à l'étage d'entrée de la figure 1, et qui commande la grille G de l'interrupteur I, par l'intermédiaire de la résistance R2.

Le circuit de protection comprenant la diode de découplage D1 et la diode Zener 22 est quant à lui couplé au circuit de commande de l'interrupteur I et plus précisément à l'entrée H de l'étage "push-pull" c'est-à-dire aux bases des transistors T2 et T1. Il conduit un courant dans la résistance R9, développant une tension qui agit sur les bases des transistors T2 et T1, dans le sens de la conduction du transistor T2 et du blocage du transistor T1, c'est-à-dire de la conduction de l'interrupteur I.

Le fonctionnement de ce circuit de commande et de l'interrupteur I est exposé ci-après.

Lorsque le potentiel de l'entrée E devient suffisamment inférieur au potentiel V+, le transistor de commande T5 se sature et fournit la tension V+, à peu près, sur les bases des transistors T2 et T1. Le transistor T2 se sature, ce qui fixe le potentiel sur la grille de commande de l'interrupteur I aux environs de V+ également. La valeur de la résistance R2 peut être librement déterminée pour les seuls besoins de l'adaptation de la sortie de l'étage "push-pull" à l'entrée de l'interrupteur ; elle peut être notamment de valeur aussi faible que nécessaire. L'interrupteur I, dont la grille est à un potentiel voisin de V+, et compte tenu du potentiel de référence par rapport auquel agit cette grille (la masse du substrat d'un dispositif à effet de champ, par exemple), devient alors conducteur, ou fermé, dans des conditions optimales. La charge C est alimentée, c'est-à-dire connectée à la masse, état qui se maintient tant que l'entrée E reste au même niveau positif.

Lorsque l'entrée E est portée au potentiel V+, le transistor de commande T5 se bloque, ce qui isole les bases des transistors T2 et T1 du potentiel V+. La charge présente dans la capacité d'entrée de l'interrupteur I est évacuée au potentiel V- par le transistor T1 qui devient conducteur, ce qui bloque rapidement et efficacement l'interrupteur I, séparant la charge C de la masse. Le gain de courant des transistors T2 et T1 peut être très élevé (on peut si nécessaire utiliser une paire de Darlington pour chacun des transistors T2 et T1), de sorte que la résistance R9 peut avoir une valeur très élevée ; la valeur de la résistance R2 n'importe pas.

Mais, au même instant, la diminution du courant dans la charge C engendre une surtension au point D. Cette surtension est due généralement à l'inductance des conducteurs qui mènent à la charge, la charge elle-même pouvant être séparément protégée contre les surtensions, si elle est inductive. La surtension est d'autant plus élevée que l'interrupteur I a un pouvoir de coupure élevé, en termes de di/dt. Elle peut atteindre ainsi des valeurs telles que l'interrupteur I en serait détruit.

Dès que cette surtension dépasse les seuils cumulés des diodes D1, Z2, augmentés de la tension résiduelle aux bornes de la résistance R9, la diode Zener devient passante et un courant est fourni sur les bases des transistors T2 et T1, rendant conducteur le premier et bloquant le second, ce qui ramène l'interrupteur I en état de conduction, à l'instar du courant fourni par le transistor T5 en réponse à un signal de commande sur l'entrée E. De la même manière et tout aussi efficacement que ce dernier, il stoppe la diminution abrupte du courant dans la charge. La pente de diminution du courant devient alors linéaire, puisque l'inductance du circuit de la charge C se décharge sous tension constante. En choisissant la tension de seuil de la diode Zener Z2 à la valeur appropriée, l'homme de métier pourra donner à cette pente l'allure souhaitée et il déterminera la valeur de la résistance R9 pour contrôler en conséquence le courant dans D1, Z2, R9 et le limiter à une valeur acceptable, sans que cela affecte le circuit de commande de l'interrupteur I.

## Revendications

1. Circuit de commande pour un interrupteur électronique (I) alimentant une charge (C), comprenant un trajet de commande de l'interrupteur s'étendant entre une entrée de signal de commande (E) et l'électrode de commande de l'interrupteur (I), ledit trajet de commande comprenant un étage d'entrée de type push-pull (T2, T1) à une entrée (H) duquel est couplée ladite entrée (E) de signal de commande, et dont la sortie est couplée à l'électrode de commande (G) de l'interrupteur électronique (I), et comprenant aussi un circuit de protection (D1, Z2) inserré entre ladite charge (C) et ledit trajet de commande, qui comprend un composant à effet de seuil (Z2) et un élément de découplage (D1) et qui est rendu passant par le courant résultant d'une surtension engendrée dans le circuit de ladite charge (C), caractérisé en ce que ce circuit de protection est couplé à l'entrée dudit étage d'entrée (T2, T1), pour agir sur ledit interrupteur (I) à l'instar d'un signal de commande de l'interrupteur (I).

2. Circuit de commande conforme à la revendication 1, caractérisé en ce que ladite entrée de l'étage d'entrée comprend un impédance (R9) dont la valeur est telle qu'elle protège les éléments du circuit de protection (Z2, D1).
